(19) Europäisches Patentamt
European Patent Office
Office européen des brevets

(11) **EP 3 944 279 B1**

(12) **FASCICULE DE BREVET EUROPEEN**

(45) Date de publication et mention de la délivrance du brevet:
**12.02.2025 Bulletin 2025/07**

(21) Numéro de dépôt: **21186413.7**

(22) Date de dépôt: **19.07.2021**

(51) Classification Internationale des Brevets (IPC):
**H01H 47/00** *(2006.01)*    **H01H 47/32** *(2006.01)*

(52) Classification Coopérative des Brevets (CPC):
**H01H 47/002; H01H 47/32;** H01H 2047/008;
H01H 2047/009

(54) **PROCÉDÉ DE DIAGNOSTIC D'UN ÉTAT DE FONCTIONNEMENT D'UN APPAREIL DE COMMUTATION ÉLECTRIQUE ET APPAREIL DE COMMUTATION ÉLECTRIQUE POUR LA MISE EN OEUVRE D'UN TEL PROCÉDÉ**

VERFAHREN ZUR DIAGNOSE DES BETRIEBSZUSTANDS EINES ELEKTRISCHEN SCHALTGERÄTS UND ELEKTRISCHES SCHALTGERÄT ZUR UMSETZUNG DIESES VERFAHRENS

METHOD FOR DIAGNOSING A STATE OF OPERATION OF AN ELECTRICAL SWITCHING DEVICE AND ELECTRICAL SWITCHING DEVICE FOR IMPLEMENTING SUCH A METHOD

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **20.07.2020 FR 2007585**

(43) Date de publication de la demande:
**26.01.2022 Bulletin 2022/04**

(73) Titulaire: **Schneider Electric Industries SAS**
**92500 Rueil-Malmaison (FR)**

(72) Inventeurs:
• **DELBAERE, Stéphane**
**38240 MEYLAN (FR)**
• **ORBAN, Rémy**
**38410 SAINT MARTIN D'URIAGES (FR)**

(74) Mandataire: **Lavoix**
**62, rue de Bonnel**
**69448 Lyon Cedex 03 (FR)**

(56) Documents cités:
EP-A1- 3 460 822    WO-A1-2015/189027
WO-A1-98/24106

**Description**

La présente invention concerne un procédé de diagnostic d'un état de fonctionnement d'un appareil de commutation électrique et un appareil de commutation électrique pour la mise en oeuvre d'un tel procédé.

L'invention concerne plus particulièrement les contacteurs électriques.

De tels appareils de commutation électrique comportent un actionneur électromagnétique comprenant une bobine et sont configurés pour commuter entre un état ouvert et un état fermé, par exemple pour commander l'alimentation électrique d'une charge électrique. Généralement, les contacts électriques comprennent des contacts fixes et des contacts mobiles, ces derniers étant liés à une partie mobile de l'actionneur qui se déplace sous l'effet d'un champ magnétique créé par la bobine lorsque celle-ci est parcourue par un courant électrique adéquat. Pour garantir une pression de contact suffisante entre les contacts électriques, la partie mobile de l'actionneur effectue une sur-course entre le moment où les contacts mobiles entrent en contact avec les contacts fixes, et le moment ou l'actionneur est en position fermée stable. Cette sur-course correspond à un écrasement de contact.

À chaque cycle de commutation, le contacteur s'use sous l'effet de divers facteurs, par exemple les contacts électriques s'usent sous l'effet d'arcs électriques lors de l'ouverture des contacts électriques, l'usure du contacteur se manifestant par une perte d'écrasement de contact.

Il est souhaitable de pouvoir estimer automatiquement le niveau d'usure d'un contacteur lorsqu'il est en fonctionnement, afin de prévoir une maintenance adaptée au cours de la vie dudit contacteur et/ou de détecter l'apparition de dysfonctionnements.

Il est connu d'intégrer à l'actionneur électromagnétique un capteur de position, pour mesurer directement le déplacement des pièces mobiles de l'actionneur et en déduire l'écrasement de contact. Cependant l'usage d'un capteur engendre un coût supplémentaire, et il n'est pas toujours possible d'intégrer un capteur à un contacteur.

WO-03/054895-A1 décrit une méthode de diagnostic d'usure basée sur une mesure du temps de parcours du noyau mobile de l'actionneur électromagnétique au cours de la phase de fermeture. Une telle méthode de diagnostic permet seulement de connaitre l'instant du début du mouvement et l'instant de la fin du mouvement du noyau. Mais un inconvénient de cette méthode est qu'elle ne permet pas de remonter à la position précise du noyau au cours de la phase de fermeture. Cela rend plus difficile l'obtention d'informations fiables sur l'état des contacts et donc sur l'état d'usure du contacteur.

WO-2015/189027-A1 décrit, par exemple, une méthode d'évaluation d'états d'un actionneur basée sur les variations de flux magnétique, mais cette méthode ne permet pas de remonter à la position précise du noyau au cours de la phase de fermeture.

C'est à ces problèmes qu'entend plus particulièrement remédier l'invention, en proposant un procédé de diagnostic qui soit plus précis.

À cet effet, l'invention concerne un procédé de diagnostic d'un état de fonctionnement d'un appareil de commutation, configuré pour être couplé à un conducteur électrique et comprenant :

- des contacts séparables associés au conducteur électrique et pilotés par un actionneur électromagnétique comprenant une bobine reliée à un dispositif électronique de contrôle, qui est configuré pour appliquer une tension bobine de commande aux bornes de la bobine, et
- des capteurs configurés pour mesurer une intensité d'un courant bobine circulant dans la bobine et la tension bobine,

dans lequel le procédé comprend les étapes consistant à :

- recevoir un ordre de fermeture de l'appareil de commutation, l'appareil de commutation étant initialement dans un état ouvert, l'ordre de fermeture étant reçu par le dispositif électronique de contrôle ;
- après avoir reçu l'ordre de fermeture, commander la fermeture de l'actionneur électromagnétique au moyen du dispositif électronique de contrôle ;
- pendant la commutation de l'appareil de commutation vers l'état fermé, mesurer et enregistrer les valeurs de tension bobine et de courant bobine ;
- calculer et enregistrer des valeurs d'un flux magnétique traversant la bobine, par intégration des valeurs enregistrées du courant bobine, de la tension bobine et des valeurs de résistance et d'inductance de la bobine, préalablement enregistrées dans le dispositif électronique de contrôle.

Selon l'invention, le procédé comprend, en outre, l'étape consistant à :

- à partir des valeurs enregistrées de flux magnétique et de courant bobine, évaluer et enregistrer des positions d'un noyau de l'actionneur électromagnétique en fonction d'une table de données caractéristique de l'actionneur électromagnétique, la table de données étant préalablement enregistrée dans le dispositif électronique de contrôle et

**EP 3 944 279 B1**

définissant une relation bijective entre la position du noyau, le flux magnétique et le courant bobine.

Grâce à l'invention, le flux magnétique est calculé tout au long de la phase de fermeture, à partir des mesures de tension bobine et de courant bobine. Une valeur de la position du noyau mobile en est déduite à partir de la table de données, qui relie de façon bijective position du noyau, flux bobine et courant bobine. L'évolution de la position du noyau mobile au cours de la phase de fermeture est ainsi obtenue automatiquement, de manière précise, sans avoir à implanter de nouveau capteur spécifique tel qu'un capteur de position, ce qui est économique.

Selon des aspects avantageux mais non obligatoires de l'invention, un tel procédé de diagnostic peut incorporer une ou plusieurs des caractéristiques suivantes prises isolément ou selon toute combinaison techniquement admissible :

- l'étape de calcul du flux magnétique comprend une sous-étape initiale dite d'autocorrection, suivie d'une sous-étape de calcul, la sous-étape d'autocorrection consistant à, tant que le courant bobine est inférieur à un courant dit « de décollage» en deçà duquel le noyau mobile est maintenu en position ouverte par un organe de rappel de l'actionneur électromagnétique, évaluer et enregistrer une valeur initiale du flux magnétique, dite « flux initial », de manière que lorsque le courant bobine croît au-delà du courant de décollage, le calcul par intégration du flux magnétique au cours de la phase de calcul tient compte de la valeur du flux initial ;
- au cours de l'étape de commande de la fermeture l'actionneur électromagnétique, le dispositif électronique de contrôle commande la fermeture de l'actionneur électromagnétique lorsque le courant bobine atteint 50% de la valeur du courant de décollage, de préférence, de préférence encore du courant de décollage ;
- le procédé comprend une étape consistant à calculer, à partir du profil de position enregistré dans le dispositif électronique de contrôle, un temps de fermeture de l'actionneur électromagnétique, le temps de fermeture étant égal à un écart temporel entre l'instant où le dispositif électronique de contrôle commande la fermeture de l'actionneur électromagnétique et l'instant où l'actionneur électromagnétique est en position stable de fermeture ;
- le procédé comprend une étape consistant à calculer, par dérivation temporelle du profil de position enregistré dans le dispositif électronique de contrôle, un profil de vitesse de déplacement de l'appareil de commutation et un profil d'accélération de l'appareil de commutation, et à enregistrer les profils de vitesse et d'accélération dans le dispositif électronique de contrôle ;
- le procédé comprend une étape consistant à calculer, à partir du profil de vitesse de l'appareil de commutation, une vitesse minimale d'écrasement du noyau, la vitesse minimale d'écrasement étant égale à un minimum de la vitesse du noyau sur une portion terminale de la course de déplacement du noyau au cours de la phase de fermeture ;
- le procédé détecte des instants précis de fermeture de chaque contact associé à chaque pôle de l'appareil de commutation au moyen de capteurs de courant, le procédé combinant le profil de vitesse enregistré dans le dispositif électronique de contrôle et les instants précis de fermeture de chaque contact pour évaluer une vitesse de fermeture de chaque contact, et
- on évalue un écrasement associé aux contacts mobiles de chaque pôle, en combinant le profil de position du noyau aux instants précis de fermeture de chaque contacts, l'écrasement de chaque contact mobile étant égal à la différence entre une position finale du noyau en position stable de fermeture et la position du noyau à l'instant précis de fermeture du contact considéré.

L'invention concerne aussi un appareil de commutation électrique pour la mise en oeuvre d'un procédé de diagnostic tel que décrit précédemment, l'appareil de commutation étant configuré pour être couplé à un conducteur électrique et comprenant :

- des contacts séparables, déplacés entre une position ouverte et une position fermée par un actionneur électromagnétique comprenant une bobine et un noyau mobile lié aux contacts séparables, l'appareil de commutation présentant une structure limitant la génération de courants d'induction ;
- un circuit de commande de la tension électrique aux bornes de la bobine, dite « tension bobine », le circuit de commande comprenant un dispositif dit « de retombée », activable sélectivement pour faire chuter le courant électrique circulant au travers de la bobine, dit « courant bobine », la tension bobine et le dispositif de retombée étant activés ou désactivés selon des états du circuit de commande ;
- des capteurs pour mesurer le courant bobine et la tension bobine ;
- un dispositif électronique de contrôle, configuré pour recevoir des ordres d'ouverture et de fermeture de l'appareil de commutation, pour recevoir les valeurs des mesures de courant bobine et de tension bobine et pour commander les états du circuit de commande ;

dans lequel l'appareil de commutation est configuré pour mettre en oeuvre un procédé de diagnostic comportant des étapes consistant à :

a) recevoir un ordre de fermeture ;

b) commander la fermeture de l'actionneur électromagnétique ;

c) mesurer et enregistrer les valeurs de tension bobine et de courant bobine ;

d) calculer et enregistrer des valeurs d'un flux magnétique traversant la bobine, par intégration des valeurs enregistrées du courant bobine, de la tension bobine et des valeurs, préalablement enregistrées dans le dispositif électronique de contrôle, de résistance et d'inductance de la bobine ;

e) à partir des valeurs enregistrées de flux magnétique et de courant bobine, évaluer et enregistrer des positions du noyau en fonction d'une table de données caractéristique de l'actionneur électromagnétique, la table de données définissant une relation bijective entre la position du noyau, le flux magnétique et le courant bobine.

Avantageusement, l'appareil de commutation comprend des capteurs de courant, configurés pour mesurer une intensité de courant électrique circulant dans chaque phase du conducteur électrique, l'appareil de commutation étant configuré pour mettre en oeuvre un procédé de diagnostic comportant des étapes consistant à détecter un instant précis de fermeture des contacts mobiles associés à chaque phase, et à combiner aux instants précis de fermeture de chacun des contacts mobiles le profil de position du noyau ou le profil de vitesse du noyau, afin d'évaluer un écrasement ou une vitesse de fermeture de chacun des contacts mobiles.

Cet appareil de commutation induit les mêmes avantages que ceux mentionnés ci-dessus au sujet du procédé de diagnostic de l'invention.

L'invention sera mieux comprise, et d'autres avantages de celle-ci apparaîtront plus clairement à la lumière de la description qui va suivre, d'un mode de réalisation d'un procédé de diagnostic d'un état de fonctionnement d'un contacteur et d'un contacteur configuré pour la mise en oeuvre d'un tel procédé, donnée uniquement à titre d'exemple et faite en référence aux dessins annexés, dans lesquels :

- [Fig 1] la figure 1 est une vue schématique d'un appareil de commutation électrique comportant un actionneur électromagnétique conforme à des modes de réalisation de l'invention ;
- [Fig 2] la figure 2 une vue schématique d'un exemple du circuit de commande de l'actionneur électromagnétique de l'appareil de commutation de la figure 1 ;
- [Fig 3] la figure 3 est un graphe représentant l'évolution d'un courant électrique de commande de l'actionneur électromagnétique de la figure 2 au cours de plusieurs phases de fonctionnement ;
- [Fig 4] la figure 4 est un graphe représentant l'évolution d'un courant électrique de commande et d'un flux magnétique de l'actionneur électromagnétique de la figure 2, mesurés au cours d'une phase de fermeture de l'actionneur ;
- [Fig 5] la figure 5 est un graphe illustrant une des étapes du procédé de diagnostic ;
- [Fig 6] la figure 6 est un graphe illustrant un résultat du procédé de diagnostic, et
- [Fig 7] la figure 7 est un diagramme représentant des étapes d'un procédé de diagnostic de propriétés de l'appareil de commutation de la figure 1 conforme à des modes de réalisation de l'invention.

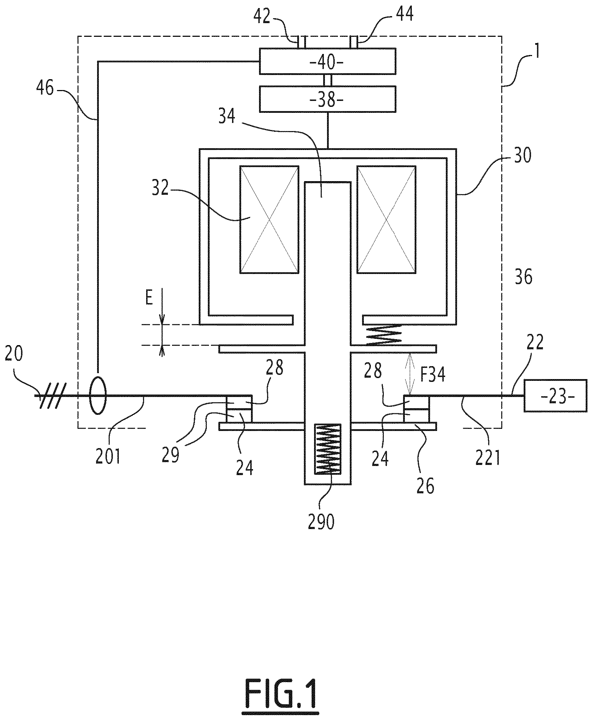

Un contacteur 1 est représenté sur la figure 1. Le contacteur 1 est un exemple d'appareil de commutation électrique destiné à commander l'alimentation en énergie électrique d'une source d'énergie électrique vers une charge électrique 23. La source d'énergie électrique n'est pas dessinée pour simplifier les figures. La source d'énergie est par exemple un réseau d'alimentation électrique, tandis que la charge électrique 23 est par exemple un moteur électrique, que l'on souhaite commander et/ou protéger au moyen du contacteur 1. Le contacteur 1 est généralement logé dans un boitier, représenté ici par un rectangle en pointillés. Le contacteur 1 est configuré pour être couplé, d'une part, à un conducteur électrique 20 amont connecté à une source d'énergie électrique et, d'autre part, à une ligne aval 22 connectée à la charge électrique 23. Lorsque le contacteur 1 laisse passer le courant électrique et que la charge électrique 23 est alimentée en énergie, le contacteur 1 est dans un état dit « fermé », tandis que lorsque le contacteur 1 empêche le passage de l'énergie électrique vers la charge électrique, le contacteur 1 est dans un état dit « ouvert ».

Le conducteur électrique 20 et la ligne aval 22 comprennent le même nombre de phases. Lorsque la source d'énergie électrique est polyphasée, les conducteurs électriques 20 et la ligne aval 22, qui comprennent chacune des fils conducteurs isolés les uns des autres, comptent autant de fils conducteurs l'un que l'autre, chaque fil conducteur de la ligne aval 22 étant associé à un fil respectif du conducteur électrique 20 amont. Quel que soit le nombre de phases, le contacteur 1 est configuré pour interrompre, ou faire passer, le courant électrique conjointement dans chacune des phases.

Dans l'exemple illustré, le conducteur électrique 20 amont est triphasé. Un seul des fils conducteurs du conducteur électrique 20, référencé 201, est représenté sur la figure 1. Seul le fil conducteur de la ligne de puissance 22 associé au conducteur 201 est représenté, ce fil conducteur de la ligne de puissance 22 étant référencé 221.

La suite de la description est faite en référence aux fils conducteurs 201 et 221, qui sont associés à une même phase du courant d'alimentation, sachant que ce qui est décrit peut être transposé aux autres phases du courant d'alimentation.

Pour chaque phase, le contacteur 1 comprend des contacts mobiles 24, disposés sur un barreau mobile 26, et des contacts fixes 28, liés respectivement aux conducteurs amont 20 et aval 22. Chacun des contacts mobiles 24 et fixes 28 comprend des pastilles de contact 29, réalisées ici en métal, de préférence en alliage d'argent ou tout matériau équivalent.

Le barreau mobile 26 est déplaçable entre une position fermée, dans laquelle les contacts mobiles 24 sont électriquement connectés aux contacts fixes 28 et l'énergie électrique peut circuler au travers du barreau mobile 26 du conducteur électrique 20 amont vers la ligne aval 22, et une position ouverte, dans laquelle les contacts mobiles 24 sont éloignés des contacts fixes 28.

Lorsque le barreau mobile 26 est en position fermée, le contacteur 1 est à l'état fermé, tandis que lorsque le barreau 26 est en position ouverte, le contacteur 1 est à l'état ouvert. Le passage de l'état ouvert à l'état fermé est une phase de fermeture du contacteur 1, tandis que le passage de l'état fermé à l'état ouvert est une phase d'ouverture du contacteur 1.

En pratique, au cours de chaque cycle comprenant une phase de fermeture et d'ouverture, les pastilles de contact 29 s'usent, par exemple sous l'action d'arcs électriques au cours de l'ouverture, ou encore par arrachement de matière causé par des microsoudures. Cette perte de matière a pour conséquence que l'épaisseur des pastilles de contact 29 se réduit tout au long de la vie du contacteur 1, ce qui augmente l'amplitude du mouvement du barreau 26 lors des phases d'ouverture ou de fermeture. Pour y remédier, le contacteur 1 comprend un mécanisme 290, représenté schématiquement par un ressort sur la figure 1, qui est lié au barreau 26 et qui permet de maintenir les contacts fixes 28 et mobiles 24 en contact électrique avec une pression de contact suffisante.

Lorsque l'épaisseur des pastilles de contact 29 est insuffisante ou que l'état de surface des pastilles 29 est mauvais, les risques de dysfonctionnement du contacteur 1 augmentent et il convient de remplacer le contacteur 1 ; c'est pour ces raisons qu'un diagnostic de l'état d'écrasement des contacts du contacteur 1 permet d'évaluer l'avancement de la dégradation du contacteur 1.

Le barreau mobile 26 est piloté par un actionneur électromagnétique 30, qui comprend électroaimant de commande avec une bobine 32, un noyau 34 lié au barreau mobile 26 et un organe de rappel 36, par exemple un ressort ou équivalent. La bobine 32 est configurée pour générer un champ magnétique lorsqu'elle est alimentée par un courant électrique de commande, afin de mettre en mouvement le noyau 34, et donc le barreau mobile 26. Les mouvements du noyau 34 entre les positions ouverte et fermée sont représentés par une double flèche F34. Autrement dit, les contacts mobiles 24 et les contacts fixes 28 associés forment ensemble des contacts séparables, qui sont associés au conducteur électrique 20 et qui sont déplacés entre une position ouverte et une position fermée par l'actionneur électromagnétique 30, qui comprend une bobine 32 et un noyau mobile 34 lié aux contacts séparables.

Sur la figure 1, le contacteur 1 est représenté dans une configuration intermédiaire entre les états ouvert et fermé stable du contacteur 1, dans laquelle les contacts fixes 28 et mobiles 24 sont électriquement connectés, mais le noyau 34 n'est pas en butée en position fermée. Le mécanisme 290 autorise une sur-course du noyau 34 entre le moment où les contacts fixes 28 entrent en contact avec les contacts mobiles 24, et le moment ou l'actionneur 30 est en position fermée stable. Cette sur-course, qui correspond à l'écrasement de contact, est notée E sur la figure 1.

L'actionneur électromagnétique 30 est commandé par l'intermédiaire d'un circuit d'alimentation 38, lui-même piloté par un dispositif électronique de contrôle 40. La bobine 32 est ainsi reliée au dispositif électronique de contrôle 40.

Selon des modes de réalisation, le dispositif électronique de contrôle 40 comporte une unité logique de calcul (CPU), telle qu'un microcontrôleur programmable ou un microprocesseur ou équivalent, et une mémoire informatique formant un support d'enregistrement de données lisibles par ordinateur.

Selon des exemples, la mémoire est une mémoire ROM, ou une mémoire RAM, ou une mémoire non volatile du type EPROM ou Flash ou équivalent. La mémoire comporte des instructions exécutables et/ou du code informatique pour assurer le fonctionnement du dispositif de contrôle 40 conformément à un ou plusieurs des modes de réalisation décrits ci-après lorsqu'exécuté par l'unité logique de calcul.

Selon des variantes, le dispositif électronique de contrôle 40 peut comporter un processeur de traitement du signal (DSP), ou un composant logique reprogrammable (FPGA), ou un circuit intégré spécialisé (ASIC), ou tout élément équivalent.

Le dispositif électronique de contrôle 40 est lui-même connecté à un rail d'alimentation 42 et comprend une interface 44 configurée pour recevoir, en provenance d'un utilisateur, des ordres d'ouverture ou de fermeture du contacteur 1. Le dispositif électronique de contrôle 40 est ici représenté comme étant intégré au contacteur 1. En variante le dispositif de contrôle 40 est déporté, c'est-à-dire qu'il n'est pas intégré dans un même boitier que l'actionneur électromagnétique 30.

Le rail d'alimentation 42 présente une tension de préférence stable et continue et est destiné à alimenter en énergie le dispositif électronique de contrôle 40 ainsi que le circuit d'alimentation 38. L'interface 44 est représentée ici par des électrodes de commande. Par exemple, une tension électrique de commande peut être appliquée entre les électrodes de commande. Optionnellement, l'interface 44 comprend des moyens de communication sans fil.

Dans certains modes de réalisation, le contacteur 1 comprend aussi des capteurs de courant 46, configurés pour mesurer un courant circulant dans chacune des phases de la ligne amont 20, autrement dit un courant circulant dans chacun des fils conducteurs 201 de la ligne amont 20. Dans d'autres modes de réalisation, les capteurs de courant 46 et le dispositif électronique de contrôle 40 sont intégré dans un boîtier distinct du contacteur 1.

Lorsque la bobine 32 est alimentée en énergie électrique fournie par le rail d'alimentation 42, un courant d'excitation passe par la bobine 32, qui génère une force électromagnétique qui tend à attirer le noyau 34 et le barreau 26 de la position ouverte vers la position fermée. Un organe de rappel 36, représenté ici par un ressort, exerce une force de rappel qui s'oppose à la force d'attraction de l'électroaimant.

On définit un courant bobine $I_{BOB}$ comme étant un courant d'excitation circulant au travers de la bobine 32.

On définit un courant de décollage $I_D$ comme étant un seuil du courant bobine $I_{BOB}$ qui, lorsque l'actionneur 1 est à l'état ouvert, permet à l'actionneur 1 de se déplacer jusqu'à l'état fermé, dès que le courant bobine $I_{BOB}$ croit au-delà du courant de décollage $I_D$.

On définit un courant de décrochage $I_S$ - ou *« stall current »* en anglais - comme étant un seuil du courant bobine $I_{BOB}$ qui, lorsque l'actionneur 1 est à l'état fermé, permet à l'actionneur 1 de se déplacer jusqu'à l'état ouvert, dès que le courant bobine $I_{BOB}$ décroit en deçà du courant de décrochage $I_S$.

Ainsi, lorsque l'actionneur 1 est à l'état ouvert, tant que le courant bobine $I_{BOB}$ reste en-deçà du courant de décollage $I_D$, le noyau mobile 34 est repoussé en position ouverte par l'organe de rappel 36 de l'actionneur 30 et le contacteur 1 reste à l'état ouvert. Si le courant bobine $I_{BOB}$ croit au-delà du courant de décollage $I_D$, la force électromagnétique de la bobine 32 devient supérieure à la force de rappel de l'organe 36 et le noyau 34 se déplace alors de sa position ouverte vers sa position fermée. Une telle situation correspond à une phase de fermeture du contacteur 1.

À l'inverse, lorsque l'actionneur 1est à l'état fermé, tant que le courant bobine $I_{BOB}$ reste supérieur au courant de décrochage $I_S$, le contacteur 1 reste à l'état fermé. Si, alors que le contacteur 1 est à l'état fermé, le courant bobine $I_{BOB}$ décroit en-deçà du courant de décrochage $I_S$, la force électromagnétique de la bobine 32 devient plus faible que la force de rappel de l'organe 36 et du mécanisme 290, le noyau 34 est alors repoussé de sa position fermée vers sa position ouverte sous l'effet de l'organe de rappel 36 et du mécanisme 290. Une telle situation correspond à une phase d'ouverture du contacteur 1.

Généralement, le courant de décollage $I_D$ est supérieur, en valeur absolue, au courant de décrochage $I_S$. Les valeurs des courants de décollage $I_D$ et de décrochage $I_S$ sont ajustées lors de la conception de l'actionneur 1, en jouant notamment sur les propriétés de la bobine 32 ou sur les forces de rappel de l'organe 36 et du mécanisme 290.

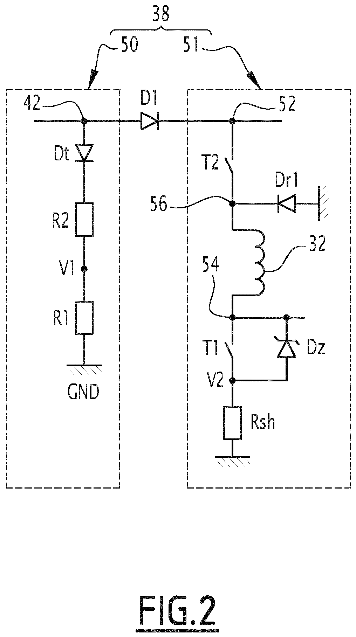

Un exemple de réalisation du circuit d'alimentation 38 est représenté schématiquement sur la figure 2. L'architecture du circuit d'alimentation 38 n'est pas limitative, et d'autres implantations des divers composants du circuit d'alimentation 38 sont possibles, voire d'autres composants électriques ou électroniques peuvent être utilisés pour remplir les mêmes fonctions.

Le circuit d'alimentation 38 comprend de préférence un circuit de mesure 50, délimité par un cadre en pointillés, configuré pour mesurer la valeur de la tension électrique entre le rail d'alimentation 42 et une masse électrique GND du circuit d'alimentation 38.

Par exemple, le circuit de mesure 50 comprend deux résistances R1 et R2 connectées en série avec une diode Dt entre le rail d'alimentation 42 et la masse électrique GND. Un premier point de mesure, ici placé entre les résistances R1 et R2, permet de collecter une première tension de mesure V1 représentative de la tension électrique présente entre le rail d'alimentation 42 et la masse électrique GND. La tension électrique présente entre le rail 42 et la masse GND étant reliée à la tension bobine $U_{BOB}$, par extension le circuit de mesure 50 est un exemple de capteur configuré pour mesurer la tension bobine $U_{BOB}$.

Le circuit d'alimentation 38 comprend un circuit de commande 51, qui inclut la bobine 32. Une diode D1 peut être placée sur le rail d'alimentation 42 entre le circuit de commande 51 et le circuit de mesure 50 pour éviter tout retour de courant vers ce dernier. Les diodes D1 et Dt sont de préférence de même type.

Le circuit de commande 51 est représenté ici dans une configuration dite « de retombée », qui est détaillée plus loin dans la présente description.

Le circuit de commande 51 comprend une borne d'alimentation 52, qui est reliée au rail d'alimentation 42. La bobine 32 comprend deux bornes 54 et 56. Une mesure de tension électrique entre les bornes 54 et 56 permet ainsi de mesurer une tension bobine, notée $U_{BOB}$.

La borne 54 est reliée à la masse GND par l'intermédiaire d'un interrupteur dit « de retombée » T1. Dans de nombreux modes de réalisation, une résistance dite « de shunt » Rsh est connectée en série avec l'interrupteur de retombée T1 pour collecter une deuxième tension de mesure V2 représentative du courant électrique traversant la bobine 32, autrement dit représentative du courant bobine $I_{BOB}$. Dans l'exemple illustré la résistance de shunt Rsh est connectée entre l'interrupteur de retombée T1 et la masse GND. La résistance Rsh est un exemple de capteur configuré pour mesurer l'intensité du courant bobine $I_{BOB}$ circulant dans la bobine 32.

La borne 56 est, d'une part, reliée à la borne 52 par l'intermédiaire d'un interrupteur d'alimentation T2 et, d'autre part, reliée à la masse GND par l'intermédiaire d'une diode, dite diode « de roue libre » Drl. La diode de roule libre Drl présente un sens bloquant orienté vers la borne 56.

Les interrupteurs T1 et T2 sont des interrupteurs pilotés par un signal de commande en provenance du dispositif électronique de contrôle 40. Autrement dit, le dispositif électronique de contrôle 40 est configuré pour commander des états du circuit de commande 51.

Selon des exemples de mise en oeuvre, les interrupteurs T1 et T2 sont des interrupteurs de puissance à semi-conducteurs, tels que des transistors Mosfet, ou des thyristors, ou des transistors bipolaires à grille isolée (IGBT), ou tout autre dispositif équivalent.

Le circuit de commande 51 comprend un dispositif « de retombée » Dz, réalisé ici au moyen d'une diode Zéner et connecté en parallèle à l'interrupteur de retombée T1. Ainsi, lorsque l'interrupteur de retombée T1 est ouvert, le courant bobine $I_{BOB}$ passe par le dispositif de retombée Dz, alors que lorsque l'interrupteur de retombée T1 est fermé, le dispositif de retombée Dz est en court-circuit et aucun courant ne passe par le dispositif de retombée Dz. Le dispositif de retombée Dz est ainsi activable sélectivement pour faire chuter le courant bobine $I_{BOB}$.

Dans le cadre de la présente invention, les grandeurs caractéristiques des composants du circuit d'alimentation 38 sont considérées comme connues. En particulier, la bobine 32 présente une résistance notée $R_{BOB}$ et une inductance notée $L_{BOB}$. La résistance $R_{BOB}$ et l'inductance $L_{BOB}$ dépendent, notamment, de la géométrie de la bobine 32, des matériaux utilisés, de la température, etc. Les valeurs des résistance $R_{BOB}$ et inductance $L_{BOB}$ sont ainsi considérées comme connues.

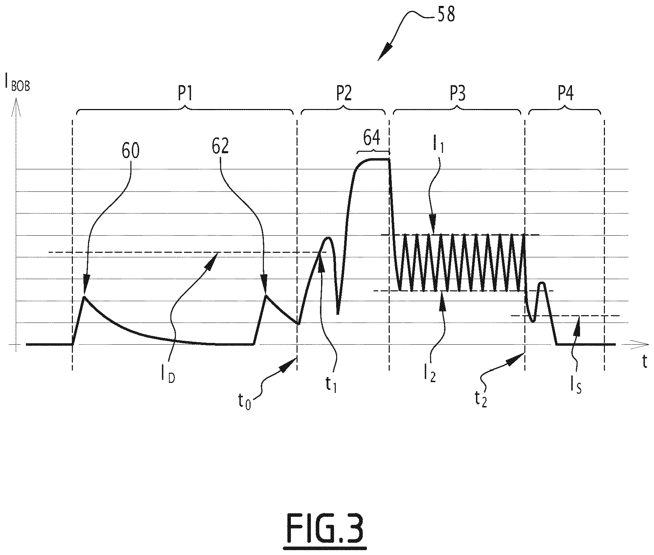

La figure 3 représente un graphique 58 illustrant l'évolution du courant bobine $I_{BOB}$ circulant dans la bobine 32 au cours du temps (t) lors de différentes phases de fonctionnement successives du contacteur 1, notées P1, P2, P3 et P4, dans le cas où le contacteur est commuté vers l'état fermé, puis à nouveau commuté vers l'état ouvert.

La phase P1 est une phase initiale, pendant laquelle le contacteur 1 est à l'état ouvert de façon stable, c'est-à-dire que le courant bobine $I_{BOB}$ ne dépasse pas le courant de décollage $I_D$. Sur la figure 3, le courant bobine $I_{BOB}$ présente des pics transitoires 60 et 62, qui sont inférieurs au courant de décollage $I_D$ et qui sont liés à des opérations de tests du contacteur 1, ces opérations de tests n'étant pas détaillées dans la présente description.

La phase P2 correspond à une phase de fermeture, après qu'un ordre de fermeture ait été reçu par le contacteur 1. La phase P2 commence lorsque le dispositif électronique de contrôle 40 reçoit, à un instant $t_0$, un ordre de fermeture par l'interface 44.

Le dispositif électronique de contrôle 40 est configuré pour appliquer la tension bobine $U_{BOB}$ de commande aux bornes de la bobine 32. Par exemple, le dispositif de contrôle 40 commande alors la fermeture de l'interrupteur de retombée T1 et de l'interrupteur d'alimentation T2. La tension bobine $U_{BOB}$ est alors égale à la tension délivrée par le rail d'alimentation 42, moins la tension aux bornes de la résistance de shunt Rsh. Le courant bobine $I_{BOB}$, initialement nul, croît alors pour dépasser le courant de décollage $I_D$ à un instant $t_1$, à partir duquel le noyau 34 commence à se déplacer de sa position ouverte vers sa position fermée.

Dans la suite de la phase de fermeture P2, les contacts mobiles 26 arrivent en appui sur les contacts fixes 28, le contacteur 1 est alors à l'état fermé. Le noyau continue de se déplacer jusqu'à entrer en contact avec la partie fixe 30 du circuit magnétique, ce qui correspond à la course d'écrasement des contacts électriques.

Plus généralement, lorsque la source d'énergie électrique comprend plusieurs phases électriques, les pastilles 29 associées à chacune des phases électriques ne présentent pas toutes la même usure, autrement dit pas le même écrasement. L'instant exact de la fermeture de chacune des phases électriques diffère selon les phases électriques.

Au cours d'une dernière phase 64 de la phase de fermeture P2, les phénomènes transitoires sont terminés, et le courant bobine $I_{BOB}$ présente une valeur plateau, égale à la tension bobine $U_{BOB}$ divisée par la résistante bobine $R_{BOB}$ et strictement supérieure au courant de décrochage $I_S$. Le contacteur 1 est alors à l'état fermé de manière stable.

Au cours de la phase 64, la bobine 32 consomme de l'énergie électrique, en particulier par effet Joule, la puissance de l'énergie électrique consommée par la bobine 32 par effet Joule étant égale à $R_{BOB} \times (I_{BOB})^2$. Or le contacteur 1 reste à l'état fermé tant que le courant bobine $I_{BOB}$ est maintenu au-dessus du courant de décrochage $I_S$. Il est donc possible de réduire la consommation énergétique de la bobine 32 tout en maintenant contacteur 1 à l'état fermé de manière stable, en réduisant l'intensité du courant bobine $I_{BOB}$, tant que le courant bobine $I_{BOB}$ reste supérieur au courant de décrochage $I_S$.

Ceci est par exemple obtenu en faisant varier la tension bobine $U_{BOB}$, de manière à réduire le plus possible le courant bobine $I_{BOB}$ tout en le maintenant au-dessus du courant de décrochage $I_S$. Une telle situation correspond à la phase de maintien P3.

Dans l'exemple illustré, la variation de la tension bobine $U_{BOB}$ est obtenue en ouvrant et fermant alternativement l'interrupteur d'alimentation T2, ce qui crée un signal périodique de hachage de la tension bobine $U_{BOB}$ suivant un profil en créneau et à une fréquence F3.

Au cours de la phase de maintien P3, lorsque l'interrupteur d'alimentation T2 est ouvert, l'interrupteur de retombée T1 reste fermé. Le circuit de commande 51 est alors dans un mode dit « roue libre », le circuit de commande 51 étant limité à la bobine 32 connectée à la diode de roue libre Drl et à la résistance de shunt Rsh. Le courant bobine $I_{BOB}$ décroit alors, l'énergie électrique étant principalement dissipée par la résistance $R_{BOB}$ de la bobine 32. L'interrupteur d'alimentation T2 est ensuite refermé avant que le courant bobine $I_{BOB}$ ne décroisse en deçà du courant de décrochage $I_S$,

et le courant bobine $I_{BOB}$ croit à nouveau.

En résultat, le courant bobine $I_{BOB}$ varie périodiquement à une fréquence égale à la fréquence F3 de la tension bobine $U_{BOB}$, le courant bobine $I_{BOB}$ présentant ici un profil en dents de scie, variant entre un seul bas $I_1$, strictement supérieur au courant de décrochage $I_S$, et un seul haut $I_2$, supérieur au seuil bas $I_1$. Le seuil bas $I_1$ est par exemple choisi supérieur de 5% du courant de décrochage $I_S$. Le seuil haut $I_2$ dépend notamment des caractéristiques de la bobine 32, telles que la résistance bobine $R_{BOB}$ et l'inductance bobine $L_{BOB}$.

La nature périodique du courant bobine $I_{BOB}$ engendre des vibrations mécaniques de l'actionneur électromagnétique 30. Pour éviter que ces vibrations ne génèrent un bruit perceptible par l'oreille humaine, la fréquence F3 est avantageusement choisie inférieure à 100 Hz, ou supérieure à 25 kHz. Dans l'exemple illustré, la fréquence F3 est de 100 Hz.

La phase P4 d'ouverture commence lorsque le dispositif électronique de contrôle 40 reçoit un ordre d'ouverture, à un instant $t_2$.

Le dispositif électronique de contrôle 40 commande l'ouverture de l'actionneur électromagnétique 30, ce qui se fait ici par ouverture de l'interrupteur d'alimentation T2 et l'ouverture de l'interrupteur de retombée T1, de manière à faire chuter la tension aux bornes de la bobine 32. Le courant bobine $I_{BOB}$ circule alors au travers de la diode de roue libre Drl, de la bobine 32, du dispositif de retombée Dz et de la résistance de shunt Rsh. Le circuit de commande 51 est alors dans un mode dit « de retombée », dans lequel le courant bobine $I_{BOB}$ décroît plus vite que dans le mode roue libre.

Lorsque le courant bobine $I_{BOB}$ passe en-deçà du courant de décrochage $I_S$, l'organe de rappel 36 et le mécanisme 290 repoussent les contacts mobiles 24 de leur position fermée vers leur position ouverte.

Une fois les phénomènes transitoires d'induction terminés, le courant bobine $I_{BOB}$ est nul, et le contacteur 1 est à nouveau à l'état ouvert de façon stable.

On s'intéresse à présent aux grandeurs électriques et électromagnétiques de la bobine 32.

Un flux magnétique $\phi$ est généré lorsque le courant bobine $I_{BOB}$ circule dans la bobine 32. La valeur du flux magnétique $\phi$ dépend notamment de la valeur du courant bobine $I_{BOB}$ et de la position du noyau mobile 34.

Par exemple, la valeur du flux magnétique $\phi$ est liée aux valeurs de tension bobine $U_{BOB}$ et de courant bobine $I_{BOB}$ selon l'équation suivante, notée Math 1 dans ce qui suit :

$$U_{BOB} = R_{BOB} \cdot I_{BOB} + N \frac{d\phi}{dt} \qquad [Math\ 1]$$

dans laquelle N est le nombre de spires de la bobine 32, et $\phi$ est le flux magnétique traversant chaque spire de la bobine 32.

On définit une position $x$ comme une position du noyau 34 par rapport à la bobine 32. Dans de nombreux modes de réalisation, le noyau 34 peut se déplacer en translation par rapport à la bobine 32 le long d'un axe de déplacement. La position $x$ est alors définie le long de cet axe de déplacement. Par convention, la position $x$ est nulle lorsque le contacteur 1 est à l'état ouvert. Pour chacune des phases électriques du contacteur 1, la position des contacts mobiles 24 est ainsi reliée à la position $x$. Par extension, la position $x$ représente aussi une position de l'actionneur électromagnétique 30 ou du contacteur 1.

En dérivant $\phi$ dans l'équation Math 1, on obtient une équation générale Math 2 régissant les grandeurs électromagnétiques dans l'actionneur 1 :

$$U_{BOB} = R_{BOB} \cdot I_{BOB} + N \frac{d\phi}{dI_{BOB}} \frac{dI_{BOB}}{dt} + N \frac{d\phi}{dx} \frac{dx}{dt} + N \frac{d\phi}{di_f} \frac{di_f}{dt} \quad [Math\ 2]$$

dans laquelle le dernier terme $N \frac{d\phi}{di_f} \frac{di_f}{dt}$ fait intervenir des courants d'induction, aussi dits courants de Foucault, notés $i_f$.

Dans le cadre de la présente invention, le contacteur 1 présente une structure limitant la génération de courants d'induction $i_f$, ce qui permet de négliger le dernier terme de l'équation Math 2. Selon des exemples non limitatifs, le contacteur 1 présente une structure en tôle feuilletée, réalisée par empilage de tôles découpées et présentant une conductivité très faible dans l'axe d'empilement des tôles, notamment du fait des discontinuités en bord de tôle. La faible conductivité globale résultante est la cause du peu de courant induits générés par ce type de contacteur 1.

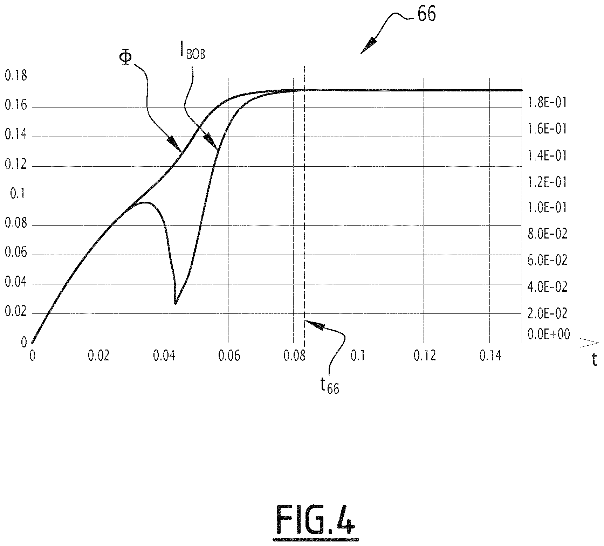

Une illustration de cet effet de réduction des courants induits $i_f$ est représentée sur la figure 4, qui représente un graphique 66 illustrant l'évolution du courant bobine $I_{BOB}$ et du flux magnétique $\phi$ au cours d'une phase de fermeture du contacteur 1. On constate l'absence de courants induits $i_f$ par l'absence de déphasage entre le flux bobine $\phi$ et le courant bobine $I_{BOB}$, qui atteignent chacun une valeur plateau au même instant.

Les courants induits étant négligés, le circuit magnétique présente une reluctance *Rel* qui est, d'une part, fonction de la position $x$ du noyau mobile 34 et du courant bobine $I_{BOB}$, et qui est, d'autre part, liée au flux magnétique $\phi$ et

au courant bobine $I_{BOB}$ par la relation suivante $Rel(x, I_{BOB}) \cdot \phi = N \cdot I_{BOB}$.

Autrement dit, le flux magnétique $\phi$ est une fonction de la position $x$ et du courant bobine $I_{BOB}$. Le flux magnétique $\phi$ peut être exprimé sous la forme d'une relation analytique, ou bien, pour une meilleure précision, par une surface de réponse bidimensionnelle générée par des outils de simulation du circuit magnétique du contacteur 1.

Dans la grande majorité des cas, la surface $\phi = f(x, I_{BOB})$ présente un caractère bijectif, c'est-à-dire que pour un courant bobine $I_{BOB}$ donné, à une valeur donnée de la position $x$ correspond une unique valeur de flux magnétique $\phi$. Ceci permet de reconstruire une fonction inverse $x = g(\phi, I_{BOB})$ donnant la valeur de la position $x$ en fonction du flux $\phi$ et du courant bobine $I_{BOB}$.

La surface $\phi = f(x, I_{BOB})$, ou bien sa fonction inverse $x = g(\phi, I_{BOB})$, est enregistrée dans la mémoire du dispositif électronique de contrôle 40, par exemple sous la forme d'une table de données caractéristique de l'actionneur électromagnétique 30, la table de données définissant une relation bijective entre la position $x$ du noyau 34, le flux bobine $\phi$ et le courant bobine $I_{BOB}$.

Le flux magnétique $\phi$ est aussi donné par intégration temporelle de l'équation Math 1. On obtient alors l'équation Math 3 ci-dessous :

$$\phi(t) = \int \frac{U_{BOB} - R_{BOB} \cdot I_{BOB}}{N} \cdot dt + \phi_0 \quad [Math\ 3]$$

dans laquelle $U_{BOB}$ et $I_{BOB}$ sont mesurés, N, $dt$ et $R_{BOB}$ sont connus et $\phi_0$ est une valeur initiale du flux magnétique $\phi$.

Le flux magnétique $\phi$ peut être calculé à partir de l'équation Math 3 selon des méthodes de calcul numérique mises en oeuvre par le dispositif électronique de contrôle 40.

Plus l'intervalle temporel d'intégration $dt$ est petit, autrement dit plus le pas d'intégration est court, et plus réduite est l'erreur de calcul. L'intervalle $dt$ est par exemple proportionnel à l'inverse d'une fréquence d'horloge de l'unité logique de calcul du dispositif électronique de contrôle 40. Selon des exemples, la fréquence d'horloge du dispositif 40 est de 1 kHz.

Lorsque le flux initial $\phi_0$ est nul, il est possible de calculer directement l'évolution de la valeur du flux $\phi$ à partir des mesures de $U_{BOB}$ et $I_{BOB}$, et de remonter, à l'aide de la fonction inverse $x = g(\phi, I_{BOB})$, à l'évolution de la position $x$ du noyau mobile 34. On a ainsi accès à la position du noyau mobile 34 au cours de la phase de fermeture du contacteur de manière précise sans avoir à installer de capteur spécifique tel qu'un capteur de position.

Dans certains cas, le flux initial $\phi_0$ n'est pas nul, par exemple lorsque certaines pièces de l'actionneur électromagnétique 30 présentent, avec le temps, une aimantation rémanente, ou bien lorsque l'actionneur électromagnétique 30 comprend, par construction, un aimant permanent. Il convient de déterminer le flux initial $\phi_0$ pour réduire l'imprécision sur le calcul de la position $x$. On définit une estimée du flux initial $\hat{\phi}_0$.

Une première méthode consiste à déterminer la valeur du flux initial $\hat{\phi}_0$ à partir de la surface de réponse $\phi = f(x, I_{BOB})$ connue, en estimant une valeur initiale de la position x, notée estimée $\hat{x}_0$. L'estimée $\hat{x}_0$ peut être calculée par exemple via l'inductance bobine L, connue, le courant bobine $I_{BOB}$ étant mesuré. On a alors $\hat{\phi}_0 = f(\hat{x}_0, I)$.

Cependant, une telle première méthode de détermination de la valeur estimée $\hat{x}_0$ de la position est relativement grossière et ne permet notamment pas de tenir compte de la variabilité des entrefers magnétiques. Par exemple, un matage des surfaces ou une pollution des surfaces en butées en position d'ouverture peut entrainer une variation de la position estimée $\hat{x}_0$ considérée comme ouverte, ce qui entraine une erreur sur l'estimée du flux initial $\hat{\phi}_0$ et donc sur la reconstruction de la position $x$ au cours de la phase de fermeture.

Une deuxième méthode, dite méthode d'autocorrection, repose sur le fait que le noyau mobile 34 reste immobile en position ouverte tant que le courant bobine $I_{BOB}$ est inférieur au courant de décollage $I_D$, c'est-à-dire entre les instants $t_0$ et $t_1$ de la phase P2.

Autrement dit, à chaque instant $t$ compris entre $t_0$ et $t_1$, tant que le courant bobine $I_{BOB}$ est inférieur au courant de décollage $I_D$, lorsque le flux magnétique $\phi$ est calculé à l'aide de l'équation Math 3 et que la position $x$ à l'instant $t$ en est déduite à l'aide de la fonction inverse $x = g(\phi, I_{BOB})$, si la position $x$ calculée n'est pas constante, autrement dit si $x(t) \neq x(t_0)$, c'est qu'il y a une erreur sur le flux initial estimé $\hat{\phi}_0$. Le flux magnétique $\phi$ à l'instant $t$ est alors compensé pour corriger cette erreur. La correction du flux magnétique $\phi$ est appliquée plusieurs fois, au cours de plusieurs calculs successifs et tant que l'instant $t$ est compris entre $t_0$ et $t_1$, jusqu'à convergence du flux initial estimé $\hat{\phi}_0$ et du flux réel $\phi_0$. En résultat de la méthode d'autocorrection, le flux initial $\phi_0$ est connu de manière précise.

Ainsi, lorsque le courant bobine $I_{BOB}$ dépasse le courant de décollage $I_D$ et que la position x commence à changer, le flux initial $\phi_0$ est estimé de manière précise, cette valeur de flux initial $\phi_0$ permettant à son tour de calculer la position $x$ de manière précise.

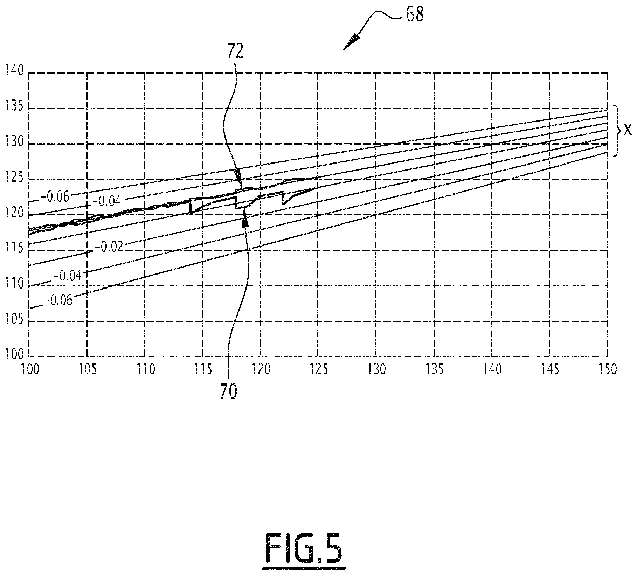

La figure 5 représente un graphique 68 illustrant un exemple de mise en oeuvre de la méthode d'autocorrection. Sur ce graphique 68, la courbe 70 représente le flux magnétique $\phi$ calculé avec autocorrection, en fonction du courant bobine $I_{BOB}$ multiplié par le nombre de spire, alors que la position $x$ initiale est fixe, et que l'estimée du flux initial $\phi_0$ est

erronée. Dans l'exemple, on a une position initiale $\hat{x}_0 = 0$ mm, alors que le flux initial $\phi_0$ est le flux magnétique correspondant à une position x = +0,02 mm. On observe des divergences du flux magnétique $\phi$ par rapport à une caractéristique correspondant à une position x fixe, amenant une série d'autocorrections jusqu'à convergence du flux estimé et du flux réel $\phi$. La convergence du flux estimé se traduit par une position x calculée stable, qui correspond à la position x réelle.

La courbe 72 représente le flux magnétique $\phi$ calculé avec autocorrection, sans erreur sur le flux initial $\phi_0$. Dans l'exemple, on a $\hat{x}_0 = +0,02$ mm, et le flux initial $\hat{\phi}_0$ est le flux magnétique correspondant à cette position x = +0,02 mm. Le flux calculé suit bien une caractéristique de position fixe et ne nécessite pas de correction.

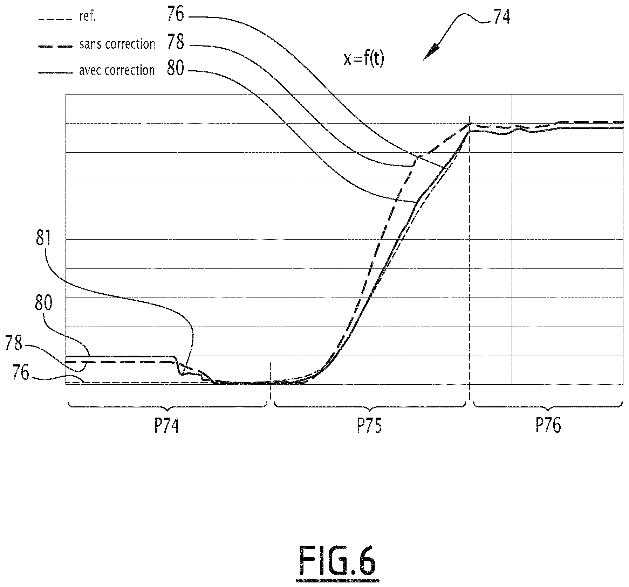

La figure 6 représente un graphique 74 illustrant l'effet de la méthode d'autocorrection pour la détermination de la position x. Une courbe 76, en pointillés, représente l'évolution de la position x, la position x étant mesurée directement à l'aide d'un capteur de position du noyau mobile 34 à des fins de comparaison avec les résultats de la méthode décrite ci-dessus. On comprend qu'en pratique, le contacteur 1 est normalement dépourvu d'un tel capteur de position.

Au cours d'une phase initiale P74, la position x mesurée reste constante. Au cours d'une phase P75, postérieure à la phase initiale P74, le noyau 34 se déplace de sa position fermée vers sa position ouverte, et la position x évolue. Au cours d'une phase P76, postérieure à la phase P75, le noyau 34 est en position d'ouverture stable, et la position x n'évolue plus.

Une courbe 78, en gros pointillés, représente l'évolution de la position x, calculée conformément à la méthode décrite ci-dessus, sans autocorrection. Le flux initial estimé $\hat{\phi}_0$ est erroné sans être corrigé.

Une courbe 80 représente l'évolution de la position x au cours d'une phase de fermeture, calculée conformément à la méthode décrite ci-dessus, avec autocorrection, alors que les conditions initiales sont identiques à celles du calcul de la courbe 78. Le flux initial estimé $\hat{\phi}_0$ est erroné, mais est corrigé.

Au cours d'une phase initiale P74, la position x reste constante. La courbe 78 présente des décrochements 81 en marche d'escalier, qui résultent de la mise en oeuvre de la procédure d'autocorrection. Par ailleurs, la courbe 78 rejoint la courbe 76 malgré l'incertitude portant sur le flux initial $\hat{\phi}_0$. En résultat, au cours des phases P75 et P76, la courbe 80 adhère plus à la courbe 76 que la courbe 78, ce qui montre l'effet positif de la méthode d'autocorrection. Il n'est pas nécessaire d'installer un capteur de position pour remonter de façon fiable à l'évolution de la position x en fonction du temps au cours de la phase de fermeture P2. La méthode d'autocorrection est avantageusement mise en oeuvre dans tous les cas, que l'actionneur électromagnétique 30 comprenne un aimant permanent ou non.

Les données de position du noyau mobile 34 ainsi générées permettent de tirer diverses informations sur l'état du contacteur 1.

Par exemple, la reconstruction de la position x = f(t) permet de vérifier la conformité de la course du noyau mobile 34 ainsi que l'état final de l'actionneur 1 afin de détecter d'éventuels défauts d'ordre mécanique.

Au travers d'un temps de fermeture, égal à un écart temporel entre l'ordre de fermeture et la fin de course mécanique de l'actionneur 1, il est possible de vérifier l'absence de frottements ou blocages d'origine mécaniques.

Par dérivation temporelle de la position x = f(t), on calcule une vitesse de déplacement du noyau mobile 34. Au cours de la phase de fermeture P2, une vitesse minimale sur la course d'écrasement des contacts mobiles 24 constitue un observateur intéressant de l'aptitude du contacteur 1 à se fermer de façon stable. Une vitesse minimale trop faible traduit un manque d'effort magnétique ou des frottements trop importants au sein du dispositif de fermeture 30.

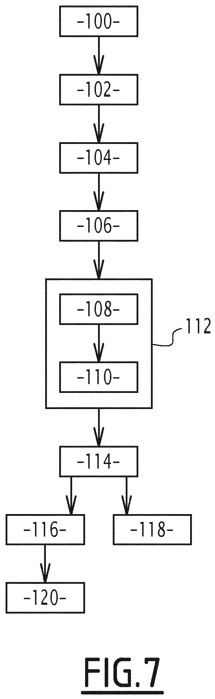

Un exemple de fonctionnement d'un procédé d'estimation de propriétés du contacteur 1 selon un mode de réalisation préféré est maintenant décrit en référence à la figure 7. Cependant, en variante, les étapes de ce procédé pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Au cours d'une étape 100, le procédé est initialisé, alors que le contacteur 1 est initialement dans un état ouvert stable, par exemple au cours de la phase initiale P1. Le dispositif électronique de contrôle 40 est en attente d'un ordre de fermeture du contacteur 1.

Ensuite, au cours d'une étape 102, le dispositif électronique de contrôle 40 reçoit un ordre de fermeture du contacteur 1. L'instant $t_0$ de réception de l'ordre de fermeture est le début de la phase de fermeture P2.

Ensuite, au cours d'une étape 104, le dispositif électronique de contrôle 40 commande la fermeture de l'actionneur 30. La commande de fermeture se fait ici en appliquant la tension bobine $U_{BOB}$ de commande aux bornes de la bobine 32 en fermant les interrupteurs T1 et T2.

Dans l'exemple illustré sur la figure 3, l'ordre de fermeture est reçu dans le cas particulier où le courant bobine $I_{BOB}$ n'est pas nul, à la suite d'un pic transitoire 62 lié à une opération de test. Selon des exemples, le courant bobine $I_{BOB}$ est nul lorsque l'ordre de fermeture est reçu. Dans tous les cas, l'actionneur électromagnétique 30 est en position ouverte stable lorsque l'ordre de fermeture est reçu et lorsque le dispositif électronique de contrôle 40 commande la fermeture de l'actionneur électromagnétique 30, c'est-à-dire que le courant bobine $I_{BOB}$ est strictement inférieur à l'intensité de décollage $I_D$.

Ensuite, au cours d'une étape 106, le dispositif électronique de contrôle 40 mesure et enregistre le courant bobine $I_{BOB}$ et la tension bobine $U_{BOB}$, les mesures continuant par exemple jusqu'à ce que l'actionneur électromagnétique 30 soit en position fermée de manière stable, ou bien pendant une durée enregistrée dans le dispositif électronique de contrôle 40, cette durée étant égale par exemple à cinq périodes d'un courant d'alimentation à 50 Hz, soit 100 ms.

Le fait que l'actionneur électromagnétique 30 est en position fermée de manière stable peut être détecté de diverses manières. Par exemple, à l'aide d'un test sur la position $x$ du noyau 34, ou bien encore lorsque le courant bobine $I_{BOB}$ atteint une valeur plateau, sensiblement égale à $U_{BOB} / R_{BOB}$, au cours de la phase 64.

Ensuite, le procédé comprend une étape 112, de calcul et d'enregistrement du flux magnétique $\phi$ traversant la bobine 32.

L'étape 112 comprend une sous-étape 110, dans laquelle le flux magnétique $\phi$ est calculé par intégration des valeurs enregistrées du courant bobine $I_{BOB}$, de la tension bobine $U_{BOB}$ et des valeurs, préalablement enregistrées dans le dispositif électronique de contrôle 40, de résistance $R_{BOB}$ et d'inductance $L_{BOB}$ de la bobine 32.

L'étape 112 comprend avantageusement une sous-étape initiale 108 d'autocorrection, antérieure à la sous-étape 110, consistant à, tant que le courant bobine $I_{BOB}$ est inférieur à l'intensité de décollage $I_D$ et que le noyau 34 est maintenu en position d'ouverte par l'organe de rappel 36 de l'actionneur 1, évaluer et enregistrer une valeur du flux initial $\phi_0$, le calcul par intégration du flux magnétique $\phi$ à la sous-étape 110 tenant compte de la valeur du flux initial $\phi_0$ calculée à la sous-étape d'autocorrection 108.

Selon des exemples, la sous-étape 108 d'autocorrection dure de l'instant $t_0$ jusqu'à l'instant $t_1$, tandis que la sous-étape 110 commence à l'instant $t_1$. Autrement dit, lorsque le courant bobine $I_{BOB}$ croît au-delà du courant de décollage $I_D$, le calcul par intégration du flux magnétique $\phi$ au cours de la sous-étape de calcul 110 tient compte de la valeur du flux initial $\hat{\phi}_0$.

De préférence, à l'étape 104 le dispositif électronique de contrôle 40 commande la fermeture de l'actionneur électromagnétique 30 lorsque le courant bobine $I_{BOB}$ est suffisamment bas, de manière que la sous-étape 108 d'autocorrection dure suffisamment longtemps pour que le calcul du flux initial $\phi_0$ converge. Ainsi, au cours de l'étape 104 de commande de fermeture de l'actionneur 30, le dispositif électronique de contrôle 40 commande la fermeture de l'actionneur électromagnétique 30 lorsque le courant bobine $I_{BOB}$ atteint 50% du courant de décollage $I_D$, de préférence 20%, de préférence encore 10% du courant de décollage $I_D$.

Ensuite, le procédé comprend une étape 114, consistant à évaluer et enregistrer la position $x$ du contacteur 1, d'une part à partir des valeurs enregistrées du flux magnétique $\phi$ et du courant bobine $I_{BOB}$ et, d'autre part, en fonction d'une table de données caractéristique de la bobine 32, la table de données étant préalablement enregistrée dans le dispositif électronique de contrôle 40 et définissant une relation bijective entre la position $x$ du noyau 34, le flux magnétique $\phi$ et le courant bobine $I_{BOB}$.

Au cours d'une étape 116 du procédé, un profil de vitesse $v$ de déplacement du contacteur 1 et un profil d'accélération $a$ du contacteur 1 sont calculés par dérivation temporelle des valeurs de position $x$ enregistrées au cours de l'étape 114. Les profils de vitesse $v$ et d'accélération $a$ sont enregistrés dans le dispositif électronique de contrôle 40. Par extensions, les profils de vitesse $v$ et d'accélération $a$ du contacteur 1 sont aussi les profils de vitesse $v$ et d'accélération $a$ de l'actionneur électromagnétique 30 ou du noyau mobile 34.

Le procédé de diagnostic selon l'invention permet de remonter de façon précise au profil de position $x$ du noyau mobile 34 en fonction du temps, ainsi qu'aux profils de vitesse $v$ et d'accélération $a$ dérivés du profil de position $x$. Ces informations peuvent être combinées de multiples manières pour surveiller l'usure de composants spécifiques du contacteur 1, par exemple les pastilles de contact 29, ou bien le mécanisme de l'actionneur électromagnétique 30.

Selon un premier exemple, une course du noyau 34, égale à la différence entre les positions du noyau 34 en position stable de fermeture et d'ouverture, est évaluée à partir du profil de position $x$. La course du noyau 34 est ensuite comparée à une valeur de référence, préalablement enregistrée dans le dispositif électronique de contrôle 40, de manière à détecter d'éventuels défauts d'ordre mécanique. La valeur de référence de la course du noyau 34 est par exemple égale à la course du noyau 34 évaluée lors d'une première mise en service du contacteur 1, lorsque le contacteur 1 est neuf.

Selon un autre exemple, un temps de fermeture de l'actionneur électromagnétique 30 est évalué à partir du profil de position $x$ enregistré dans le dispositif électronique de contrôle 40, le temps de fermeture étant égal à un écart temporel entre l'instant où, à l'étape 104, le dispositif électronique de contrôle 40 commande la fermeture de l'actionneur électromagnétique 30 et l'instant où l'actionneur 30 est en position stable de fermeture, est évalué à partir du profil de position $x$ enregistré dans le dispositif électronique de contrôle 40. Le temps de fermeture de l'actionneur 30 est ensuite comparé à une valeur de référence, préalablement enregistrée dans le dispositif électronique de contrôle 40 de manière à détecter l'absence de frottements ou blocages d'origine mécaniques. La valeur de référence de la course du noyau 34 est par exemple une spécification du fabricant du contacteur 1, ou bien encore égale au temps de fermeture mesuré lors d'une première mise en service du contacteur 1, lorsque le contacteur 1 est neuf.

Selon un autre exemple encore, au cours d'une étape 120, on calcule une vitesse minimale d'écrasement du noyau 34, la vitesse minimale d'écrasement étant égale à un minimum de la vitesse $v$ du noyau 34 sur une portion terminale de la course de déplacement du noyau 34 au cours de la phase de fermeture. Par exemple, la portion terminale de la course de déplacement du noyau 34 est située entre la position $x$ correspondant à l'instant où les contacts 24 et 28 se touchent et la position où l'actionneur 30 est fermé et stable.

La vitesse minimale d'écrasement est ensuite comparée à une valeur de référence, préalablement enregistrée dans le dispositif électronique de contrôle 40.

La vitesse minimale d'écrasement du noyau 34 constitue un observateur intéressant de l'aptitude du contacteur 1 à se fermer de façon stable. Une vitesse minimale d'écrasement trop faible est le signe que l'effort magnétique de l'actionneur électromagnétique 30 est trop faible, ou bien que le mécanisme présente des frottements trop importants. Ainsi si la vitesse minimale d'écrasement du noyau 34 est inférieure à la valeur de référence, le dispositif électronique de contrôle 40 envoie un signal d'alerte à un opérateur.

Selon d'autres exemples, lorsque le contacteur 1 est relié à une source d'énergie polyphasée, en particulier triphasée, le profil de position $x = f(t)$ est combiné à d'autres mesures sur chacun des pôles du contacteur 1, par exemple à des mesures de courant réalisées au moyen des capteurs 46. Les états d'usure des pastilles de contact 29 associées à chacun des pôles étant a priori différents, au cours d'une phase de fermeture P2 du contacteur 1, les pastilles de contact 29 n'établissent pas le contact électrique au même moment. Il y a donc une désynchronisation des pôles liée à la dispersion ou à l'usure des pièces du contacteur 1.

Par exemple, comme décrit dans la demande WO-03/054895-A1, des mesures de courant sont réalisées sur chacun des pôles du contacteur 1. L'apparition du courant dans chacun des pôles permet de détecter des instants de fermeture des contacts 24 associés à chaque pôle. En combinant cette information avec le profil de position $x = f(t)$ du noyau 34, obtenu grâce à la présente invention et enregistré dans le dispositif électronique de contrôle 40, il est possible d'évaluer précisément une position des contacts 24 lorsqu'ils entrent en contact avec les contacts fixes 28 correspondants, et d'en déduire un écart d'écrasement associé aux contacts de chacun des pôles du contacteur 1.

On définit une position finale $\hat{x}_{end}$ comme étant une position stable du noyau 34 en position de fermeture. Pour chaque contact 24 considéré, l'écrasement de ce contact est égal à la différence entre la position finale $\hat{x}_{end}$ et la position du noyau 34 à l'instant précis de fermeture du contact 24 considéré.

Dans l'exemple particulier d'un contacteur 1 comprenant trois pôles, chacun associés à une phase d'une source d'énergie triphasée, les contacts 29 associés à chacun des pôles se ferment successivement. À la fermeture des premiers contacts mobiles 24, appelé premiers contacts 24A, aucun courant ne peut encore circuler.

On définit une position $\hat{x}_{i1}$ comme étant la position du noyau 34 lorsque les premiers contacts 24A arrivent en contact avec les contacts fixes 28 correspondants. Une différence entre la position $\hat{x}_{i1}$ et la position finale $\hat{x}_{end}$ définit une estimation de l'écrasement des premiers contacts 24A. Autrement dit, $Ecr_1 = \hat{x}_{i1} - \hat{x}_{end}$.

Lors de la fermeture des deuxièmes contacts mobiles 24, appelés deuxièmes contacts 24B, un courant $i_2$ apparait et circule entre les premiers contacts 24A et deuxièmes contacts 24B. Le courant $i_2$ est détecté par le capteur de courant 46. La position $x$ du noyau 34 à cet instant, appelée position $\hat{x}_{i2}$, est donc la position du noyau 34 lorsque les deuxièmes contacts 24B arrivent en contact avec les contacts fixes 28 correspondants.

Une différence entre la position $\hat{x}_{i2}$ des deuxièmes contacts 24B et la position finale $\hat{x}_{end}$ définit une estimation de l'écrasement des deuxièmes contacts 24B, noté $Ecr_2$. Autrement dit, $Ecr_2 = \hat{x}_{i2} - \hat{x}_{end}$.

Lors de la fermeture des troisièmes contacts mobiles 24, appelés troisièmes contacts 24C, un courant $i_3$ apparait et circule entre les trois pôles du contacteur 1. La position $x$ du noyau 34 à cet instant, appelée position $\hat{x}_{i3}$, est donc la position du noyau 34 lorsque les troisièmes contacts 24B arrivent en contact avec les contacts fixes 28 correspondants.

La différence entre la position $\hat{x}_{i3}$ des troisièmes contacts 24C et la position finale $\hat{x}_{end}$ définit une estimation de l'écrasement des troisièmes contacts, noté $Ecr_3$. Autrement dit $Ecr_3 = \hat{x}_{i3} - \hat{x}_{end}$.

Dans le cas de l'alimentation d'une charge électrique 23 triphasée telle qu'un moteur, seuls les écrasements $Ecr_2$ et $Ecr_3$ sont mesurés, car seuls les instants d'apparition des courants $i_2$ et $i_3$ sont détectés. En revanche l'écrasement $Ecr_1$ des premiers contacts 24A ne peut pas être mesuré car aucun courant n'apparait lorsque les premiers contacts 24A entrent en contact avec les contacts fixes 28 correspondants, on peut seulement déduire que l'écrasement $Ecr_1$ des premiers contacts 24A est supérieur à l'écrasement $Ecr_2$ des deuxièmes contacts 24B.

Selon d'autres exemples, en combinant les informations relatives aux instants d'apparition des courants sur chacun des pôles avec le profil de vitesse $v$ du noyau 34, obtenu grâce à la présente invention et enregistré dans le dispositif électronique de contrôle 40, il est possible d'évaluer la précisément une vitesse des contacts 24 lorsqu'ils entrent en contact avec les contacts fixes 28 correspondants, et d'en déduire un écart d'écrasement associé aux contacts de chacun des pôles du contacteur 1.

Dans l'exemple illustré, le dispositif électronique de contrôle 40 remplit à la fois les fonctions de pilotage de l'actionneur électromagnétique 30 et de mise en œuvre du procédé de diagnostic selon l'invention.

En variante non représentée, le procédé de diagnostic est mis en œuvre par un dispositif électronique spécifique, qui est rajouté à un contacteur 1 existant lors d'une opération de maintenance. Un tel dispositif spécifique n'a besoin, pour mettre en œuvre le procédé de diagnostic selon l'invention, que des mesures du courant bobine $I_{BOB}$, de tension bobine $U_{BOB}$ et éventuellement des mesures des courants de puissance circulant dans la ligne amont 20.

Selon une autre variante, lorsqu'un contacteur 1 comprend un dispositif électronique de contrôle 40 qui n'est pas configuré pour mettre en œuvre le procédé de diagnostic selon l'invention, si les capteurs de courant bobine et de tension bobine sont présents, il est possible de configurer le dispositif électronique de contrôle 40 du contacteur 1 pour qu'il puisse mettre en œuvre le procédé de diagnostic selon l'invention, par exemple en remplaçant physiquement le dispositif électronique de contrôle 40 ou bien, le cas échéant, en changeant le code informatique du dispositif électronique de contrôle 40.

Les modes de réalisation et les variantes mentionnées ci-dessus peuvent être combinés entre eux pour générer de nouveaux modes de réalisation de l'invention.

## Revendications

1. Procédé de diagnostic d'un état de fonctionnement d'un appareil de commutation (1), configuré pour être couplé à un conducteur électrique (20) et comprenant :

   - des contacts séparables (24, 28) associés au conducteur électrique et pilotés par un actionneur électromagnétique (30) comprenant une bobine (32) reliée à un dispositif électronique de contrôle (40), qui est configuré pour appliquer une tension bobine ($U_{BOB}$) de commande aux bornes de la bobine,
   - des capteurs (Rsh, 50) configurés pour mesurer une intensité d'un courant bobine ($I_{BOB}$) circulant dans la bobine et la tension bobine ($U_{BOB}$),
   dans lequel le procédé comprend les étapes consistant à :

   a) recevoir (102) un ordre de fermeture de l'appareil de commutation, l'appareil de commutation étant initialement dans un état ouvert, l'ordre de fermeture étant reçu par le dispositif électronique de contrôle ;
   b) après avoir reçu l'ordre de fermeture, commander (104) la fermeture de l'actionneur électromagnétique (30) au moyen du dispositif électronique de contrôle (40) ;
   c) pendant la commutation de l'appareil de commutation (1) vers l'état fermé, mesurer et enregistrer (106) les valeurs de tension bobine ($U_{BOB}$) et de courant bobine ($I_{BOB}$) ;
   d) calculer et enregistrer (112) des valeurs d'un flux magnétique ($\phi$) traversant la bobine (32), par intégration des valeurs enregistrées du courant bobine, de la tension bobine et des valeurs de résistance ($R_{BOB}$) et d'inductance ($L_{BOB}$) de la bobine, préalablement enregistrées dans le dispositif électronique de contrôle ;

   **caractérisé en ce que** le procédé comprend, en outre, l'étape consistant à :
   (e) à partir des valeurs enregistrées de flux magnétique ($\phi$) et de courant bobine ($I_{BOB}$), évaluer et enregistrer (114) des positions (x) d'un noyau (34) de l'actionneur électromagnétique (30) en fonction d'une table de données caractéristique de l'actionneur électromagnétique, la table de données étant préalablement enregistrée dans le dispositif électronique de contrôle (40) et définissant une relation bijective entre la position (x) du noyau (34), le flux magnétique ($\phi$) et le courant bobine ($I_{BOB}$).

2. Procédé selon la revendication précédente, dans lequel l'étape (112) de calcul du flux magnétique ($\phi$) comprend une sous-étape initiale (108) dite d'autocorrection, suivie d'une sous-étape (110) de calcul, la sous-étape d'autocorrection consistant à, tant que le courant bobine ($I_{BOB}$) est inférieur à un courant dit « de décollage » ($I_D$) en deçà duquel le noyau mobile (34) est maintenu en position ouverte par un organe de rappel (36) de l'actionneur électromagnétique (30), évaluer et enregistrer une valeur initiale du flux magnétique *($\phi$)*, dite « flux initial » ($\phi_0$), de manière que lorsque le courant bobine ($I_{BOB}$) croît au-delà du courant de décollage ($I_D$), le calcul par intégration du flux magnétique ($\phi$) au cours de la phase de calcul (110) tient compte de la valeur du flux initial ($\phi_0$).

3. Procédé selon la revendication précédente, dans lequel au cours de l'étape (104) de commande de la fermeture l'actionneur électromagnétique (30), le dispositif électronique de contrôle (40) commande la fermeture de l'actionneur électromagnétique lorsque le courant bobine ($I_{BOB}$) atteint 50% de la valeur du courant de décollage ($I_D$), de préférence 20%, de préférence encore 10% du courant de décollage ($I_D$).

4. Procédé selon l'une quelconque des revendications précédentes, dans lequel le procédé comprend une étape (118) consistant à calculer, à partir du profil de position (*x*) enregistré dans le dispositif électronique de contrôle (40), un temps de fermeture de l'actionneur électromagnétique (30), le temps de fermeture étant égal à un écart temporel entre l'instant où le dispositif électronique de contrôle (40) commande la fermeture (104) de l'actionneur électromagnétique (30) et l'instant où l'actionneur électromagnétique (30) est en position stable de fermeture.

5. Procédé selon l'une quelconque des revendications précédentes, dans lequel le procédé comprend une étape (116) consistant à calculer, par dérivation temporelle du profil de position (*x*) enregistré dans le dispositif électronique de contrôle (40), un profil de vitesse (*v*) de déplacement de l'appareil de commutation (1) et un profil d'accélération (*a*) de l'appareil de commutation, et à enregistrer les profils de vitesse (*v*) et d'accélération ($\alpha$) dans le dispositif électronique de contrôle (40).

6.  Procédé selon la revendication précédente, dans lequel le procédé comprend une étape (120) consistant à calculer, à partir du profil de vitesse (*v*) de l'appareil de commutation (1), une vitesse minimale d'écrasement du noyau (34), la vitesse minimale d'écrasement étant égale à un minimum de la vitesse (*v*) du noyau (34) sur une portion terminale de la course de déplacement du noyau (34) au cours de la phase de fermeture.

7.  Procédé selon l'une des revendications 5 ou 6, dans lequel le procédé détecte des instants précis de fermeture de chaque contact (24) associé à chaque pôle de l'appareil de commutation (1) au moyen de capteurs de courant (46), le procédé combinant le profil de vitesse (*v*) enregistré dans le dispositif électronique de contrôle (40) et les instants précis de fermeture de chaque contact (24) pour évaluer une vitesse de fermeture de chaque contact (24).

8.  Procédé selon la revendication précédente, dans lequel on évalue un écrasement (*Ecr₁*, *Ecr₂*, *Eer₃*) associé aux contacts mobiles (24) de chaque pôle, en combinant le profil de position (*x*) du noyau (34) aux instants précis de fermeture de chaque contacts (24), l'écrasement de chaque contact mobile (24) étant égal à la différence entre une position finale ($\hat{x}_{end}$) du noyau (34) en position stable de fermeture et la position (*x*) du noyau (34) à l'instant précis de fermeture du contact (24) considéré.

9.  Appareil de commutation électrique (1) pour la mise en oeuvre d'un procédé de diagnostic conforme à l'une quelconque des revendications 1 à 6, l'appareil de commutation étant configuré pour être couplé à un conducteur électrique (20) et comprenant :

    - des contacts séparables (24, 28), déplacés entre une position ouverte et une position fermée par un actionneur électromagnétique (30) comprenant une bobine (32) et un noyau mobile (34) lié aux contacts séparables, l'appareil de commutation présentant une structure limitant la génération de courants d'induction ;
    - un circuit de commande (51) de la tension électrique aux bornes de la bobine (32), dite « tension bobine » ($U_{BOB}$), le circuit de commande comprenant un dispositif dit « de retombée » (Dz), activable sélectivement pour faire chuter le courant électrique circulant au travers de la bobine (32), dit « courant bobine » ($I_{BOB}$), la tension bobine et le dispositif de retombée étant activés ou désactivés selon des états du circuit de commande (38) ;
    - des capteurs (Rsh, 50) pour mesurer le courant bobine ($I_{BOB}$) et la tension bobine ($U_{BOB}$) ;
    - un dispositif électronique de contrôle (40), configuré pour recevoir des ordres d'ouverture et de fermeture de l'appareil de commutation, pour recevoir les valeurs des mesures de courant bobine et de tension bobine et pour commander les états du circuit de commande ;

    dans lequel l'appareil de commutation est configuré pour mettre en oeuvre un procédé de diagnostic comportant des étapes consistant à :

    a) recevoir (102) un ordre de fermeture ;
    b) commander (104) la fermeture de l'actionneur électromagnétique (30) ;
    c) mesurer et enregistrer (106) les valeurs de tension bobine ($U_{BOB}$) et de courant bobine ($I_{BOB}$) ;
    d) calculer et enregistrer (112) des valeurs d'un flux magnétique ($\phi$) traversant la bobine (32), par intégration des valeurs enregistrées du courant bobine, de la tension bobine et des valeurs, préalablement enregistrées dans le dispositif électronique de contrôle (40), de résistance ($R_{BOB}$) et d'inductance ($L_{BOB}$) de la bobine ;
    e) à partir des valeurs enregistrées de flux magnétique ($\phi$) et de courant bobine ($I_{BOB}$), évaluer et enregistrer (114) des positions (*x*) du noyau (34) en fonction d'une table de données caractéristique de l'actionneur électromagnétique (30), la table de données définissant une relation bijective entre la position (*x*) du noyau (34), le flux magnétique ($\phi$) et le courant bobine ($I_{BOB}$).

10. Appareil de commutation (1) selon la revendication précédente, dans lequel l'appareil de commutation comprend des capteurs de courant (46), configurés pour mesurer une intensité de courant électrique circulant dans chaque phase du conducteur électrique (20), l'appareil de commutation étant configuré pour mettre en oeuvre un procédé de diagnostic comportant des étapes consistant à détecter un instant précis de fermeture des contacts mobiles (24) associés à chaque phase, et à combiner aux instants précis de fermeture de chacun des contacts mobiles (24) le profil de position (*x*) du noyau (34) ou le profil de vitesse (*v*) du noyau (34), afin d'évaluer un écrasement ou une vitesse de fermeture de chacun des contacts mobiles.

**Patentansprüche**

1. Verfahren zum Diagnostizieren eines Betriebszustands eines Schaltgeräts (1), das konfiguriert ist, um mit einem elektrischen Leiter (20) gekoppelt zu sein, und umfassend:

   - trennbare Kontakte (24, 28), die mit dem elektrischen Leiter assoziiert sind und von einem elektromagnetischen Aktuator (30) angesteuert werden, umfassend eine Spule (32), die mit einer elektronischen Steuervorrichtung (40) verbunden ist, die konfiguriert ist, um eine Steuerspulenspannung ($U_{BOB}$) an die Anschlüsse der Spule anzulegen,
   - Sensoren (Rsh, 50), die konfiguriert sind, um eine Intensität eines Spulenstroms ($I_{BOB}$), der in der Spule fließt, und die Spulenspannung ($U_{BOB}$) zu messen,
   wobei das Verfahren die folgenden Schritte umfasst:

   a) Empfangen (102) eines Schließbefehls von dem Schaltgerät, wobei das Schaltgerät anfänglich in einem offenen Zustand ist, wobei der Schließbefehl von der elektronischen Steuervorrichtung empfangen wird;
   b) nach Empfangen des Schließbefehls, Anordnen (104) des Schließens des elektromagnetischen Aktuators (30) mittels der elektronischen Steuervorrichtung (40);
   c) während des Umschaltens des Schaltgeräts (1) in den geschlossenen Zustand, Messen und Aufzeichnen (106) der Werte der Spulenspannung ($U_{BOB}$) und des Spulenstroms ($I_{BOB}$);
   d) Berechnen und Aufzeichnen (112) von Werten eines Magnetflusses ($\phi$) durch die Spule (32) durch Integration der aufgezeichneten Werte des Spulenstroms, der Spulenspannung und der Werte des Widerstands ($R_{BOB}$) und der Induktivität ($L_{BOB}$) der Spule, die zuvor in der elektronischen Steuervorrichtung aufgezeichnet wurden;

   **dadurch gekennzeichnet, dass** das Verfahren ferner den Schritt umfasst, der aus Folgendem besteht:
   (e) anhand der aufgezeichneten Werte des magnetischen Flusses ($\phi$) und des Spulenstroms ($I_{BOB}$), Auswerten und Aufzeichnen (114) von Positionen (x) eines Kerns (34) des elektromagnetischen Aktuators (30) abhängig von einer Datentabelle, die für den elektromagnetischen Aktuator charakteristisch ist, wobei die Datentabelle zuvor in der elektronischen Steuervorrichtung (40) gespeichert wurde und ein bijektives Verhältnis zwischen der Position ($x$) des Kerns (34), dem magnetischen Fluss ($\phi$) und dem Spulenstrom ($I_{BOB}$) definiert.

2. Verfahren nach dem vorherigen Anspruch, wobei der Schritt (112) eines Berechnens des magnetischen Flusses ($\phi$) einen anfänglichen Teilschritt (108) genannt Autokorrektur umfasst, gefolgt von einem Teilschritt (110) eines Berechnens, wobei der Teilschritt einer Autokorrektur darin besteht, dass, solange der Spulenstrom ($I_{BOB}$) kleiner ist als ein sogenannter "Startstrom" ($I_D$), unterhalb dessen der bewegliche Kern (34) durch ein Rückstellorgan (36) des elektromagnetischen Aktuators (30) in der offenen Position gehalten wird, Bewerten und Aufzeichnen eines Anfangswerts des magnetischen Flusses ($\phi$) genannt "Anfangsfluss" ($\phi_0$), sodass, wenn der Spulenstrom ($I_{BOB}$) über den Startstrom ($I_D$) hinaus ansteigt, die integrative Berechnung des magnetischen Flusses ($\phi$) während der Berechnungsphase (110) den Wert des Anfangsflusses ($\phi_0$) berücksichtigt.

3. Verfahren nach dem vorherigen Anspruch, wobei während des Schritts (104) eines Anordnens des Schließens des elektromagnetischen Aktuators (30) die elektronische Steuervorrichtung (40) das Schließen des elektromagnetischen Aktuators steuert, wenn der Spulenstrom ($I_{BOB}$) 50 % des Wertes des Startstroms ($I_D$), vorzugsweise 20 %, bevorzugter 10 % des Startstroms ($I_D$), erreicht.

4. Verfahren nach einem der vorherigen Ansprüche, wobei das Verfahren einen Schritt (118) umfasst, der darin besteht, anhand des in der elektronischen Steuervorrichtung (40) gespeicherten Positionsprofils ($x$), eine Schließzeit des elektromagnetischen Aktuators (30) zu berechnen, wobei die Schließzeit gleich wie ein zeitlicher Abstand zwischen dem Zeitpunkt, an dem die elektronische Steuervorrichtung (40) das Schließen (104) des elektromagnetischen Betätigers (30) anordnet, und dem Zeitpunkt, an dem der elektromagnetische Aktuator (30) in der stabilen Schließposition ist, ist.

5. Verfahren nach einem der vorherigen Ansprüche, wobei das Verfahren einen Schritt (116) umfasst, der darin besteht, durch zeitliche Ableitung des in der elektronischen Steuervorrichtung (40) aufgezeichneten Positionsprofils ($x$) ein Geschwindigkeitsprofil ($v$) der Bewegung des Schaltgeräts (1) und ein Beschleunigungsprofil ($a$) des Schaltgeräts und Aufzeichnen des Geschwindigkeitsprofils ($v$) und des Beschleunigungsprofils ($a$) in der elektronischen Steuervorrichtung (40).

**6.** Verfahren nach dem vorherigen Anspruch, wobei das Verfahren einen Schritt (120) umfasst, der darin besteht, anhand des Geschwindigkeitsprofils ($v$) des Schaltgeräts (1) eine minimale Quetschgeschwindigkeit des Kerns (34) zu berechnen, wobei die minimale Quetschgeschwindigkeit gleich wie ein Minimum der Geschwindigkeit ($v$) des Kerns (34) über einen Endabschnitt des Bewegungshubs des Kerns (34) während der Schließphase ist.

**7.** Verfahren nach einem der Ansprüche 5 oder 6, wobei das Verfahren mittels Stromsensoren (46) genaue Schließzeitpunkte von jedem Kontakt (24) erfasst, der mit jedem Pol des Schaltgeräts (1) assoziiert ist, wobei das Verfahren das in der elektronischen Steuereinrichtung (40) gespeicherte Geschwindigkeitsprofil ($v$) und die genauen Schließzeitpunkte von jedem Kontakt (24) kombiniert, um eine Schließgeschwindigkeit von jedem Kontakt (24) zu bewerten.

**8.** Verfahren nach dem vorherigen Anspruch, wobei eine Quetschung ($Ecr_1, Ecr_2, Ecr_3$), die mit den beweglichen Kontakten (24) von jedem Pol assoziiert ist, bewertet wird, indem das Positionsprofil (x) des Kerns (34) mit den genauen Schließzeitpunkten von jedem Kontakt (24) kombiniert wird, wobei die Quetschung von jedem beweglichen Kontakt (24) gleich wie die Differenz zwischen einer Endposition ($\hat{x}_{end}$) des Kerns (34) in der stabilen Schließposition und der Position (%) des Kerns (34) an dem genauen Zeitpunkt des Schließens des jeweiligen Kontakts (24) ist.

**9.** Elektrisches Schaltgerät (1) zum Implementieren eines Diagnoseverfahrens nach einem der Ansprüche 1 bis 6, wobei das Schaltgerät konfiguriert ist, um mit einem elektrischen Leiter (20) gekoppelt zu werden, und umfassend:

- trennbare Kontakte (24, 28), die zwischen einer offenen und einer geschlossenen Position durch einen elektromagnetischen Aktuator (30) bewegt werden, der eine Spule (32) und einen beweglichen Kern (34) umfasst, der mit den trennbaren Kontakten verbunden ist, wobei das Schaltgerät eine Struktur aufweist, die die Erzeugung von Induktionsströmen begrenzt;
- eine Steuerschaltung (51) der elektrischen Spannung an den Klemmen der Spule (32), genannt "Spulenspannung" ($U_{BOB}$), wobei die Steuerschaltung eine sogenannte "Rückfallvorrichtung" (Dz) umfasst, die selektiv aktiviert werden kann, um den elektrischen Strom abfallen zu lassen, der durch die Spule (32) fließt, genannt "Spulenstrom" ($I_{BOB}$), wobei die Spulenspannung und die Rückfallvorrichtung gemäß den Zuständen der Steuerschaltung (38) aktiviert oder deaktiviert werden;
- Sensoren (Rsh, 50) zum Messen des Spulenstroms ($I_{BOB}$) und der Spulenspannung ($U_{BOB}$) ;
- eine elektronische Steuereinrichtung (40), die konfiguriert ist, um Befehle zum Öffnen und Schließen des Schaltgeräts zu empfangen, die Werte der Messungen des Spulenstroms und der Spulenspannung zu empfangen und die Zustände der Steuerschaltung anzuordnen;

wobei das Schaltgerät konfiguriert ist, um ein Diagnoseverfahren zu implementieren, umfassend die folgenden Schritte:

a) Empfangen (102) eines Schließbefehls;
b) Anordnen (104) des Schließens des elektromagnetischen Aktuators (30);
c) Messen und Aufzeichnen (106) der Werte der Spulenspannung ($U_{BOB}$) und des Spulenstroms ($I_{BOB}$);
d) Berechnen und Aufzeichnen (112) von Werten eines magnetischen Flusses ($\phi$) durch die Spule (32) durch Integration der aufgezeichneten Werte des Spulenstroms, der Spulenspannung und der zuvor in der elektronischen Steuervorrichtung (40) aufgezeichneten Werte des Widerstands ($R_{BOB}$) und der Induktivität ($L_{BOB}$) der Spule;
e) anhand der aufgezeichneten Werte des magnetischen Flusses ($\phi$) und des Spulenstroms ($I_{BOB}$), Auswerten und Aufzeichnen (114) von Positionen ($x$) des Kerns (34) abhängig von einer Datentabelle, die für den elektromagnetischen Aktuator (30) charakteristisch ist, wobei die Datentabelle ein bijektives Verhältnis zwischen der Position (x) des Kerns (34), dem magnetischen Fluss ($\phi$) und dem Spulenstrom ($I_{BOB}$) definiert.

**10.** Schaltgerät (1) nach dem vorherigen Anspruch, wobei die Schaltvorrichtung Stromsensoren (46) umfasst, die konfiguriert sind, um eine elektrische Stromstärke zu messen, die in jeder Phase des elektrischen Leiters (20) fließt, wobei die Schaltvorrichtung konfiguriert ist, um ein Diagnoseverfahren zu implementieren, umfassend Schritte, die darin bestehen, ein genauen Zeitpunkts eines Schließens der beweglichen Kontakte (24), die mit jeder Phase assoziiert sind, und eines Kombinierens des Positionsprofils (x) des Kerns (34) oder des Geschwindigkeitsprofils ($v$) des Kerns (34) mit den genauen Zeitpunkten des Schließens jedes der beweglichen Kontakte (24) umfasst, um eine Quetschung oder eine Schließgeschwindigkeit jedes der beweglichen Kontakte zu bewerten.

**Claims**

1. A method of diagnosing an operating state of a switching device (1), configured to be coupled to an electrical conductor (20) and comprising:

   - separable contacts (24, 28) associated with the electrical conductor and controlled by an electromagnetic actuator (30) comprising a coil (32) connected to an electronic control device (40), which is configured to apply a control coil voltage ($U_{BOB}$) across the coil terminals,
   - sensors (Rsh, 50) configured to measure a magnitude of a coil current ($I_{BOB}$) flowing in the coil and the coil voltage ($U_{BOB}$),

   wherein the method comprises the steps of:

   a) receiving (102) an opening command from the switching device, the switching device initially being in an open state, the closing command being received by the electronic control device;
   b) after receiving the closing command, commanding (104) the electromagnetic actuator (30) to close by means of the electronic control device (40);
   c) while the switching device (1) is switched to the closed state, measuring and recording (106) the coil voltage ($U_{BOB}$) and coil current ($I_{BOB}$) values;
   d) calculating and recording (112) values of a magnetic flow ($\phi$) passing through the coil (32), by integrating the recorded values of the coil current, the coil voltage and the resistance ($R_{BOB}$) and inductance ($L_{BOB}$) values of the coil, previously recorded in the electronic control device;

   **characterised in that** the method further comprises the step consisting of:
   (e) from the recorded of magnetic flow ($\phi$) and coil current ($I_{BOB}$) values, evaluate and record (114) positions ($x$) of a core (34) of the electromagnetic actuator (30) as a function of a data table characteristic of the electromagnetic actuator, the data table being previously recorded in the electronic control device (40) and defining a bijective relationship between the position ($x$) of the core (34), the magnetic flow ($\phi$) and the coil current ($I_{BOB}$).

2. Method according to the preceding claim, in which the step (112) of calculating the magnetic flux ($\phi$) comprises an initial sub-step (108) known as self-correction, followed by a calculation sub-step (110), the self-correction sub-step consisting in, as long as the coil current ($I_{BOB}$) is less than a current known as "take-off current" ($I_D$) below which the moving core (34) is held in the open position by a return member (36) of the electromagnetic actuator (30), evaluating and recording an initial value of the magnetic flow ($\phi$), known as the "initial flux" ($\phi_0$), so that when the coil current ($I_{BOB}$) increases beyond the take-off current ($I_D$), the calculation by integration of the magnetic flow ($\phi$) during the calculation phase (110) takes account of the value of the initial flow ($\phi_0$).

3. A method according to the preceding claim, in which during the step (104) of controlling closure of the electromagnetic actuator (30), the electronic control device (40) controls closure of the electromagnetic actuator when the coil current ($I_{BOB}$) reaches 50% of the value of the take-off current ($I_D$), preferably 20%, still more preferably 10% of the take-off current ($I_D$).

4. A method according to any one of the preceding claims, wherein the method comprises a step (118) consisting in calculating, from the position profile ($x$) recorded in the electronic control device (40), a closing time of the electromagnetic actuator (30), the closing time being equal to a time difference between the instant when the electronic control device (40) commands closure (104) of the electromagnetic actuator (30) and the instant when the electromagnetic actuator (30) is in the stable closed position.

5. A method according to any one of the preceding claims, wherein the method comprises a step (116) of calculating, by time derivation from the position profile ($x$) recorded in the electronic control device (40), a velocity profile ($v$) of movement of the switching device (1) and an acceleration profile ($a$) of the switching apparatus, and recording the velocity ($v$) and acceleration ($a$) profiles in the electronic control device (40).

6. A method according to the preceding claim, wherein the method comprises a step (120) of calculating, from the velocity profile ($v$) of the switching apparatus (1), a minimum crush velocity of the core (34), the minimum crush velocity being equal to a minimum of the velocity ($v$) of the core (34) over an end portion of the displacement stroke of the core (34) during the course of the movement stroke.

7. A method according to one of claims 5 or 6, wherein the method detects precise instants of closure of each contact (24) associated with each pole of the switchgear (1) by means of current sensors (46), the method combining the velocity profile ($v$) recorded in the electronic monitoring device (40) and the precise closing times of each contact (24) to evaluate a closing velocity of each contact (24).

8. A method according to the preceding claim, in which a collapse ($Ecr_1$, $Ecr_2$, $Ecr_3$) associated with the movable contacts (24) of each pole is evaluated by combining the position profile ($x$) of the core (34) at the precise closing instants of each contact (24), the crushing of each movable contact (24) being equal to the difference between an end position ($\hat{x}_{end}$) of the core (34) in a stable closed position and the position ($x$) of the core (34) at the precise instant of closure of the contact (24) in question.

9. Electrical switching apparatus (1) for implementing a diagnostic method according to any one of claims 1 to 6, the switching apparatus being configured to be coupled to an electrical conductor (20) and comprising:

- separable contacts (24, 28), moved between an open position and a closed position by an electromagnetic actuator (30) comprising a coil (32) and a moving core (34) linked to the separable contacts, the switching device having a structure limiting the generation of induction currents;
- a control circuit (51) for controlling the electrical voltage at the terminals of the coil (32), referred to as the "coil voltage" ($U_{BOB}$), the control circuit comprising a "fallback" device (Dz) which can be activated selectively to cause the electric current flowing through the coil (32), referred to as the "coil current" ($I_{BOB}$), to fall the coil voltage and the fallback device being activated or deactivated depending on the states of the control circuit (38);
- sensors (Rsh, 50) for measuring the coil current ($I_{BOB}$) and coil voltage ($U_{BOB}$);
- an electronic control device (40), configured to receive commands to open and close the switching device, to receive the values of the coil current and coil voltage measurements and to control the states of the control circuit;

wherein the switching apparatus is configured to implement a diagnostic method comprising the steps of:

a) receiving (102) a closing order;
b) commanding (104) the opening of the electromagnetic actuator (30);
c) measuring and recording (106) the coil voltage ($U_{BOB}$) and coil current ($I_{BOB}$) values;
d) calculating and recording (112) values of a magnetic flow ($\phi$) passing through the coil (32), by integrating the recorded values of the coil current, the coil voltage and the values, previously recorded in the electronic control device (40), for the resistance ($R_{BOB}$) and inductance ($L_{BOB}$) of the coil;
e) from the recorded magnetic flow ($\phi$) and coil current ($I_{BOB}$) values, evaluating and recording (114) positions ($x$) of the core (34) as a function of a data table characteristic of the electromagnetic actuator (30), the data table defining a bijective relationship between the position ($x$) of the core (34), the magnetic flow ($\phi$) and the coil current ($I_{BOB}$).

10. A switchgear apparatus (1) according to the preceding claim, wherein the switchgear apparatus comprises current sensors (46), configured to measure a magnitude of electrical current flowing in each phase of the electrical conductor (20), the switchgear apparatus being configured to implement a diagnostic method comprising steps of detecting a precise closure time of the movable contacts (24) associated with each phase, and combining with the precise closure times of each of the movable contacts (24) the positional profile ($x$) of the core (34) or the velocity profile ($v$) of the core (34) in order to evaluate crushing or a closure velocity of each of the movable contacts.

FIG.1

**FIG.2**

FIG.3

FIG.4

FIG.5

ref. 76

sans correction 78

avec correction 80

x=f(t) 74

81

80

78

76

P74

P75

P76

FIG.6

FIG.7

## RÉFÉRENCES CITÉES DANS LA DESCRIPTION

**Documents brevets cités dans la description**

- WO 03054895 A1

- WO 2015189027 A1